# EUROPEAN PATENT APPLICATION

(11) **EP 4 734 724 A1**
(43) Date of publication of application: **29.04.2026**
(21) Application number: 24907839.5
(22) Date of filing: 26.11.2024
(51) Int. Cl.: H10K 59/80, H10H 20/855, H10H 20/85

(54) **GLARE-FREE FILM AND DISPLAY DEVICE COMPRISING SAME**

(30) Priority: 21.12.2023 KR 20230188553; 26.04.2024 KR 20240056083
(71) Applicant: Samsung Electronics Co., Ltd., Suwon-si, Gyeonggi-do 16677 (KR)
(72) Inventor: JANG, Wonyeop, Suwon-si, Gyeonggi-do 16677 (KR); JANG, Naewon, Suwon-si, Gyeonggi-do 16677 (KR); KIM, Seunggi, Suwon-si, Gyeonggi-do 16677 (KR); JU, Seongsig, Suwon-si, Gyeonggi-do 16677 (KR)
(74) Representative: Appleyard Lees IP LLP
(86) International application number: PCT/KR2024/018832
(87) International publication number: WO 2025/135554

(57) **Abstract**

A glare-free film includes a substrate; a diffusion layer on an upper surface of the substrate and including a plurality of protrusions protruding from an upper surface of the diffusion layer; and a low-reflection layer on the upper surface of the diffusion layer. The plurality of protrusions of the diffusion layer protrude to a height greater than a height of an upper surface the low-reflection layer.

## Description

### [Technical Field]

The disclosure relates to a glare-free film and a display device having the same.

### [Background Art]

Generally, a display device includes a display panel configured to display an image.

A display surface of the display panel that displays the image is made of glass. Regular reflection of external light occurs easily due to the glass. Accordingly, a viewer looking at the display device may see an external appearance, that is, the appearance of a place where the display device is disposed, reflected on the display surface of the display device. In other words, the display device may act like a mirror.

When the external appearance is reflected on the display device, the immersion of the viewer watching the image displayed on the display device may be reduced.

In addition, in the case which the display device is turned off, when the external appearance is reflected on the display surface of the display device, it is not aesthetically pleasing.

### [Disclosure of Invention]

### [Technical Solution]

Additional aspects will be set forth in part in the description which follows and, in part, will be apparent from the description, or may be learned by practice of the presented embodiments.

According to one or more embodiments of the disclosure, a glare-free film may include a substrate; a diffusion layer on an upper surface of the substrate and including a plurality of protrusions protruding from an upper surface of the diffusion layer; and a low-reflection layer on the upper surface of the diffusion layer. The plurality of protrusions of the diffusion layer may protrude to a height greater than a height of an upper surface the low-reflection layer.

According to one or more embodiments of the disclosure, the glare-free film may have glossiness of 20 GU or less.

According to one or more embodiments of the disclosure, the glare-free film may have specular common included (SCI) reflectance of 2% or less.

According to one or more embodiments of the disclosure, a ratio between an area of the plurality of protrusions and an area of the diffusion layer may be greater than or equal to 30% and less than or equal to 40%.

According to one or more embodiments of the disclosure, a haze of the diffusion layer may be 30% or more.

According to one or more embodiments of the disclosure, a plurality of particles may form the plurality of protrusions, and the diffusion layer may include a flat portion having the plurality of particles fixed thereon. The flat portion may be formed of a solution. A mixing ratio of the solution and the plurality of particles may be 8 to 1.

According to one or more embodiments of the disclosure, the solution may be formed of a photocurable polymer. The plurality of particles may be formed of silica.

According to one or more embodiments of the disclosure, a size of the plurality of particles may be 2.7 ± 0.6*µ*m.

According to one or more embodiments of the disclosure, the substrate may be formed of a polyethylene terephthalate (PET) film or a tri-acetly-cellulose (TAC) film.

According to one or more embodiments of the disclosure, the PET film may be an optical PET film containing a ultraviolet (UV) absorber or an optical PET film manufactured by a monoaxial/biaxial stretching method.

According to one or more embodiments of the disclosure, a refractive index of the diffusion layer is not equal to a refractive index of the low-reflection layer.

According to one or more embodiments of the disclosure, a display device may include a display panel; and a glare-free film on a front surface of the display panel. The glare-free film may include a substrate; a diffusion layer on an upper surface of the substrate and including a plurality of protrusions protruding from an upper surface of the diffusion layer; and a low-reflection layer on the upper surface of the diffusion layer. The plurality of protrusions of the diffusion layer may protrude to a height greater than a height of an upper surface the low-reflection layer.

According to one or more embodiments of the disclosure, the glare-free film may have glossiness of 20 GU or less.

According to one or more embodiments of the disclosure, the glare-free film may have specular common included (SCI) reflectance of 2% or less.

According to one or more embodiments of the disclosure, the diffusion layer may have haze of 30% or more.

### [Brief Description of Drawings]

These and/or other aspects, features, and advantages of certain embodiments of the disclosure will be more apparent from the following description taken in conjunction with the accompanying drawings, in which:
FIG. 1 is a partial enlarged cross-sectional view illustrating a glare-free film according to one or more embodiments of the disclosure.
FIG. 2 is a plan view illustrating a glare-free film according to one or more embodiments of the disclosure.
FIG. 3 is a conceptual view for explaining a method of forming a diffusion layer of a glare-free film according to one or more embodiments of the disclosure.
FIG. 4 is a cross-sectional view illustrating a display device including a glare-free film according to one or more embodiments of the disclosure.
FIG. 5 is a perspective view illustrating a display device including a glare-free film according to one or more embodiments of the disclosure.
FIG. 6 is an exploded perspective view illustrating the display device illustrated in FIG. 5 according to one or more embodiments of the disclosure.
FIG. 7 is an exploded perspective view illustrating a light source part of the display device illustrated in FIG. 6 according to one or more embodiments of the disclosure.
FIG. 8 is an exploded perspective view illustrating a light source part of the display device illustrated in FIG. 6 according to one or more embodiments of the disclosure.
FIG. 9 is an exploded perspective view illustrating a display device including a glare-free film according to one or more embodiments of the disclosure.

### [Best Mode for Carrying out the Invention]

Various embodiments of this document and terms used herein are not intended to limit the technical features described in this document to specific embodiments, but should be understood to include various modifications, equivalents, or alternatives of the embodiments.

In connection with the description of the drawings, similar reference numbers may be used for similar or related components.

The singular form of a noun corresponding to an item may include one or more of the above item, unless the relevant context clearly indicates otherwise.

In this document, each of phrases such as "A or B," "at least one of A and B," "at least one of A or B," "A, B, or C," "at least one of A, B, and C," "at least one of A, B, C" may include any one of the items listed together with the corresponding phrase, or any possible combination thereof.

The term "and/or" includes any element of a plurality of related described elements or a combination of a plurality of related described elements.

Terms such as "first," "second," "primary," or "secondary" may be used simply to distinguish one component from other components, and do not limit the corresponding components in other respects (e.g., importance or order).

When it is mentioned that one (e.g., first) component is "coupled" or "connected" to another (e.g., second) component with or without terms "functionally" or "communicatively", it means that the one component can be connected to the another component directly (e.g., wired), wirelessly, or through a third component.

Terms such as "include" or "have" are intended to designate the presence of features, numbers, steps, operations, components, parts, or combinations thereof described in the embodiment, but do not preclude the presence or addition of one or more other features, numbers, steps, operations, components, parts, or combination thereof.

When a component is said to be "connected," "coupled," "supported," or "in contact" with another component, this means not only cases where the components are directly connected, coupled, supported, or contacted, but also cases where the components are indirectly connected, coupled, supported, or contacted through a third component.

When a component is said to be located "on" other component, this includes not only cases where the component is in contact with the other component, but also cases where another component exits between the two components.

Further, the terms 'leading end', 'rear end', 'upper side', 'lower side', 'top end', 'bottom end', etc. used in the disclosure are defined with reference to the drawings. However, the shape and position of each component are not limited by the terms.

The disclosure relates to a glare-free film configured to enhance viewer immersion by minimizing light reflection occurring on a display surface of a display device, and to a display device having the same.

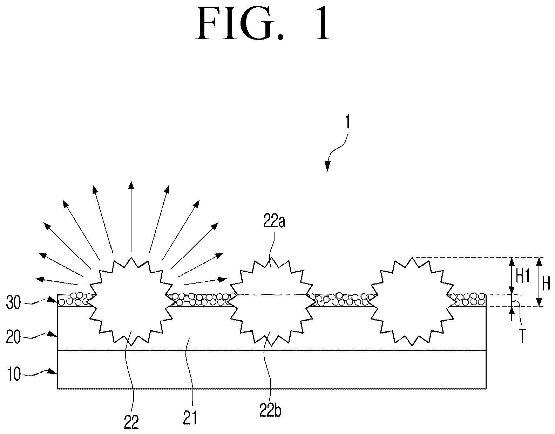

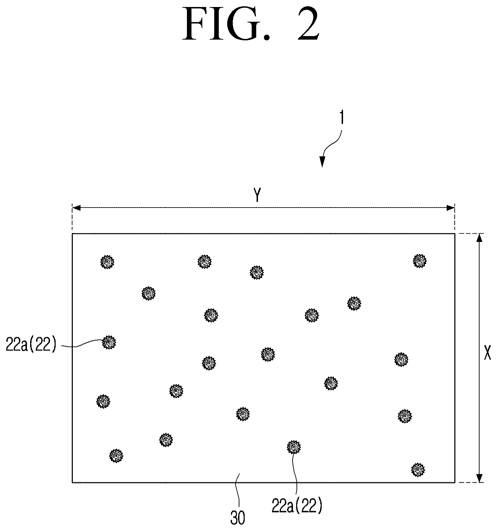

Hereinafter, a glare-free film 1 according to one or more embodiments of the disclosure will be described with reference to FIGS. 1 and 2.

FIG. 1 is a partial cross-sectional enlarged view illustrating a glare-free film 1 according to one or more embodiments of the disclosure. FIG. 2 is a plan view illustrating a glare-free film 1 according to one or more embodiments of the disclosure.

Referring to FIG. 1, a glare-free film 1 according to one or more embodiments of the disclosure may include a substrate 10, a diffusion layer 20, and a low-reflection layer 30.

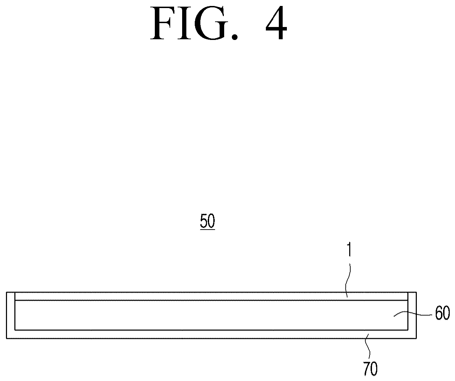

The substrate 10 forms a base of the glare-free film 1. The substrate 10 may be attached to a display surface of a display panel 60 (see FIG. 4).

The substrate 10 may be formed of a transparent film.

For example, the substrate 10 may be formed of a polyethylene terephthalate (PET) film.

In detail, the PET film may be formed as an optical PET film containing an ultraviolet (UV) absorber. Alternatively, the PET film may be formed as an optical PET film manufactured by a uniaxial stretching method. Alternatively, the PET film may be formed as an optical PET film manufactured by a biaxial stretching method.

As another example, the substrate 10 may be formed of a tri-acetly-cellulose film (TAC film).

The diffusion layer 20 may be configured so as to scatter and diffuse incident light. The diffusion layer 20 is disposed on the upper surface of the substrate 10, and may include a plurality of protrusions 22a protruding from one surface the diffusion layer 20. The plurality of protrusions 22a may protrude from the upper surface of the diffusion layer 20. The diffusion layer 20 may scatter light incident from the outside due to the plurality of protrusions 22a.

The plurality of protrusions 22a may be configured to have a defined area ratio. For example, the plurality of protrusions 22a may be configured to occupy an area of 50% or less of the area of the diffusion layer 20. As one example, the area ratio of the plurality of protrusions 22a to the area of the diffusion layer 20 may be about 30% to 40%.

In the case of FIG. 2, the area of the diffusion layer 20 is X x Y, and the area of the plurality of protrusions 22a refers to the sum total of the cross-sectional areas of the plurality of protrusions 22a protruding from the diffusion layer 20. In the case where the plurality of protrusions 22a are formed by the plurality of particles 22, the area of the plurality of protrusions 22a refers to the sum total of the maximum cross-sectional areas of the plurality of particles 22.

When the area ratio of the plurality of protrusions 22a is less than 30%, the diffusion layer 20 may not effectively scatter external light. In this case, the external appearance, for example, the appearance of the place where the display device 50 (see FIG. 4) is disposed, may be reflected on the diffusion layer 20.

When the area ratio of the plurality of protrusions 22a exceeds 40%, the diffusion layer 20 may effectively scatter external light, but the image quality of the image displayed by the display panel 60 may deteriorate.

The diffusion layer 20 may include a flat portion 21 and a plurality of protrusions 22a. The plurality of protrusions 22a are formed to protrude from the flat portion 21. The plurality of protrusions 22a may protrude from the upper surface of the flat portion 21 to a certain height H.

The plurality of protrusions 22a may be formed of a plurality of particles 22. For example, a single particle 22 may form a single protrusion 22a.

The plurality of particles 22 may be fixed to the flat portion 21. The plurality of particles 22 may be fixed to the flat portion 21 such that the plurality of particles 22 are attached to the flat portion 21 and unable to be moved after being attached thereon. The lower portion 22b of each of the plurality of particles 22 may be fixed by the flat portion 21, and the upper portion 22a thereof may protrude from the upper surface of the flat portion 21. Accordingly, the upper portion 22a of the particle 22 forms a protrusion.

The size of each of the plurality of particles 22 may be 2.7 ± 0.6 *µ*m. For example, the plurality of particles 22 may be fine particles. About 30% to 50% of each of the plurality of particles 22 may be exposed from one surface of the flat portion 21. For example, the upper portion 22a of the particle 22 corresponding to about 30% to 50% of the particle 22 may protrude upward from the upper surface of the flat portion 21. Accordingly, the protrusion 22a protruding from the upper surface of the flat portion 21 may be about 30% to 50% of the particle 22.

Each of the plurality of particles 22 may be formed into an irregular shape. The plurality of particles 22 may not be formed into a spherical or egg-shaped with a smooth surface. The plurality of particles 22 may be formed into crushed pieces.

The surfaces of the plurality of particles 22 may be formed to be rough. The surfaces of the plurality of particles 22 may be formed to scatter incident light. Therefore, the light incident on the plurality of particles 22 may not be regularly reflected but may be diffusely reflected.

FIG. 1 illustrates a case where each of the plurality of particles 22 is formed into a sphere having a rough surface; however, this is for convenience of illustration and embodiments of the disclosure are not limited thereto. Each of the plurality of particles 22 according to the disclosure may include unevenness formed on the surface of the particle 22. The unevenness of each of the plurality of particles 22 may have different sizes. As another example, the particle 22 may have a sphere, an egg shape, or an irregular three-dimensional shape.

The flat portion 21 may be formed of a transparent material capable of fixing the plurality of particles 22. For example, the flat portion 21 may be formed of a material capable of functioning as a binder.

The flat portion 21 may be formed of a transparent polymer. For example, the flat portion 21 may be formed of a photocurable polymer.

The flat portion 21 may be formed from a solution. For example, when the solution is solidified, the flat portion 21 of the diffusion layer 20 may be formed.

The plurality of particles 22 may be formed of a material capable of scattering light incident from the outside. For example, the plurality of particles 22 may be formed of silica. As an example, the plurality of particles 22 may be formed by crushing silica.

The diffusion layer 20 may be formed in the form of a solution. For example, the diffusion layer 20 may be formed of a diffusion layer solution containing the plurality of particles 22.

In this case, a mixing ratio of the solution and the plurality of particles 22 may be 8:1. For example, the diffusion layer solution may be a mixture of solution, particles, and other materials in a ratio of about 8:1:1. The other materials may include additives, accelerators, etc. other than the plurality of particles 22.

When the diffusion layer solution containing the plurality of particles 22 is applied to the upper surface of the substrate 10 and the solution is solidified, the diffusion layer 20 may be formed on the upper surface of the substrate 10. At this time, when the thickness of the solution applied is made smaller than the maximum size of the plurality of particles 22, the upper portions of the plurality of particles 22 may protrude above the solution to form the plurality of protrusions 22a. The lower portions 22b of the plurality of particles 22 may be accommodated inside the diffusion layer 20. For example, the lower portions 22b of the plurality of particles 22 may be fixed by the diffusion layer 20.

When the diffusion layer 20 is formed with the structure as described above, the haze of the diffusion layer 20 may be 30% or more.

The low-reflection layer 30 may be disposed on the upper surface of the diffusion layer 20. The low-reflection layer 30 may be configured to minimize the reflection of external light. For example, the low-reflection layer 30 may be configured so that the specular component included (SCI) reflectance is 0.5% to 1.0%.

The low-reflection layer 30 may uses a low-reflection film according to the prior art. For example, the low-reflection layer 30 may include an inorganic powder and a binder configured to bind the inorganic powder.

The inorganic powder may be formed in the form of particles. The size of the inorganic powder may be very small compared to the size of the plurality of particles 22. For example, the size of the inorganic powder may be tens of times smaller than the particles 22. Therefore, the size of the inorganic powder is smaller than the size of the upper portion of each of the particles 22, that is, the protrusions 22a.

The inorganic powder may include hollow silica and silica nano particles. The size of the inorganic powder is much smaller than the sizes of the plurality of particles 22. For example, the size of the hollow silica may be 50 nm to 60 nm, and the size of the silica nano particles may be 10 nm to 20 nm.

The low-reflection layer 30 may be configured with a thickness T lower than the height H of the plurality of protrusions 22a of the diffusion layer 20. Accordingly, the plurality of protrusions 22a of the diffusion layer 20 may protrude above the low-reflection layer 30. In other words, the plurality of protrusions 22a of the diffusion layer 20 may protrude to a height H greater than a height (i.e. thickness T) of an upper surface the low-reflection layer 30. For example, the plurality of protrusions 22a of the diffusion layer 20 may penetrate the low-reflection layer 30 and protrude from the upper surface of the low-reflection layer 30. The plurality of protrusions 22a may protrude from the upper surface of the low-reflection layer 30 to a certain height H1.

The low-reflection layer 30 may be formed in the form of a solution. A solution configured to form the low-reflection layer 30 may be referred to as a low-reflection solution.

The low-reflection layer 30 may be formed by applying the low-reflection solution to the upper surface of the diffusion layer 20. At this time, the low-reflection solution may be applied so that the thickness of the application is smaller than the height of the plurality of protrusions 22a of the diffusion layer 20. When the low-reflection solution is applied to the upper surface of the diffusion layer 20, the low-reflection solution flows down from the plurality of protrusions 22a of the diffusion layer 20, so that the plurality of protrusions 22a may protrude above the low-reflection layer 30.

In order to reduce the reflectivity of external light of the glare-free film 1 according to one or more embodiments of the disclosure, the diffusion layer 20 and the low-reflection layer 30 may be formed to have different refractive indices.

For example, the low-reflection layer 30 may be configured to have a lower refractive index than the diffusion layer 20. In other words, the refractive index of the diffusion layer 20 may be configured to be greater than the refractive index of the low-reflection layer 30.

As another example, the diffusion layer 20 may be configured to have a lower refractive index than the low-reflection layer 30. In other words, the refractive index of the low-reflection layer 30 may be configured to be greater than the refractive index of the diffusion layer 20.

When the refractive index of the diffusion layer 20 and the refractive index of the low-reflection layer 30 are configured to be different from each other as described above, the reflectivity of external light may be reduced.

The glare-free film 1 according to one or more embodiments of the disclosure having the structure as described above may lower the SCI reflectivity because the plurality of protrusions 22a protruding above the low-reflection layer 30 lower the intensity of the regular reflection of external light and induce diffuse reflection of external light.

In addition, the external light reflected from the low-reflection layer 30 is diffusely reflected by the plurality of protrusions 22a protruding from the low-reflection layer 30, so the SCI reflectivity may be further lowered.

Therefore, the glossiness of the glare-free film 1 according to one or more embodiments of the disclosure may be 20 gloss unit (GU) or less. For example, the glossiness of the glare-free film 1 may be about 9 to 13 GU. Here, the glossiness refers to the glossiness measured at 60 degrees.

In addition, the SCI reflectivity of the glare-free film 1 according to one or more embodiments of the disclosure may be 2 % or less. For example, the SCI reflectivity of the glare-free film 1 may be about 0.9 % to 1.1 %.

In addition, the haze of the glare-free film 1 according to one or more embodiments of the disclosure may be 30 % or more. When the haze is 30% or more, the rainbow phenomenon due to double refraction may be improved, so that the external light reflection felt by the viewer may be reduced.

Therefore, the glare-free film 1 according to one or more embodiments of the disclosure having a small reflectivity, a large haze, and a small glossiness may prevent or minimize the external appearance from being reflected by the glare-free film 1.

Comparison of the specifications of the glare-free film 1 according to one or more embodiments of the disclosure with various films according to the prior art used to prevent external appearance from reflecting on the display surface of the display device 50 (see FIG. 4) is disclosed in Table 1 below.

**[Table 1]**

| Type | The disclosure | Conventional AGLR film | LR film | AG film |
|---|---|---|---|---|
| SCI reflectivity | 0.9~1.1% | 0.4~1.5% | 0.5~0.8% | 4.5% |
| Haze | 30% | 5~20% | 0.5% | 20~50% |
| Glossiness(GU) (60 degrees) | 9~13 | 30~40 | 50~60 | 10~25 |

Referring to Table 1, the conventional AGLR film, that is, the anti-glare low reflection film according to the prior art, has an SCI reflectivity of 0.4 % to 1.5 %, which is similar to the SCI reflectivity of the glare-free film 1 according to one or more embodiments of the disclosure. However, the haze of the conventional AGLR film is 5% to 20%, which is smaller than the haze of the glare-free film 1 according to one or more embodiments of the disclosure. In addition, the glossiness of the conventional AGLR film is 30 GU to 40 GU, which is larger than the glossiness of the glare-free film 1 according to one or more embodiments of the disclosure. Therefore, because the conventional AGLR film has a smaller haze and a larger glossiness compared to the haze and glossiness of the glare-free film 1 according to one or more embodiments of the disclosure, the external appearance may be better reflected in the conventional AGLR film than in the glare-free film 1 according to one or more embodiments of the disclosure.

The LR film, that is, the low-reflection film, has an SCI reflectivity of 0.5% to 0.8%, which is lower than the SCI reflectivity of the glare-free film 1 according to one or more embodiments of the disclosure. However, the haze of the LR film is 0.5%, which is much lower than the haze of the glare-free film 1 according to one or more embodiments of the disclosure. In addition, the glossiness of the LR film is 50 GU to 60 GU, which is larger than the glossiness of the glare-free film 1 according to one or more embodiments of the disclosure.

Therefore, because the LR film has a smaller haze and a larger glossiness compared to the haze and glossiness of the glare-free film 1 according to one or more embodiments of the disclosure, the external appearance may be better reflected in the LR film than in the glare-free film 1 according to one or more embodiments of the disclosure.

The AG film, that is, the anti-glare film, has an SCI reflectivity of 4.5 %, which is much greater than the SCI reflectivity of the glare-free film 1 according to one or more embodiments of the disclosure. However, the haze of the AG film is 20% to 50%, which is similar to or greater than the haze of the glare-free film 1 according to one or more embodiments of the disclosure. In addition, the glossiness of the AG film is 10 GU to 25 GU, which is larger than the glossiness of the glare-free film 1 according to one or more embodiments of the disclosure.

Therefore, because the SCI reflectivity and glossiness of the AG film are greater than those of the glare-free film 1 according to one or more embodiments of the disclosure, the external appearance may be better reflected in the AG film than in the glare-free film 1 according to one or more embodiments of the disclosure.

When the glare-free film 1 according to one or more embodiments of the disclosure having the structure as described above is disposed on a display device 50 (see FIG. 4), the phenomenon of an external appearance being reflected on the front surface of the display device 50 as perceived by the viewer may be reduced, so that the image quality of the display device 50 may be improved. Accordingly, the viewer's immersion in an image displayed on the display device 50 may be improved.

Hereinafter, a method of manufacturing a glare-free film 1 according to one or more embodiments of the disclosure will be described.

A method of manufacturing a glare-free film 1 according to one or more embodiments of the disclosure may include preparing a substrate 10, forming a diffusion layer 20 on an upper surface of the substrate 10, and forming a low-reflection layer 30 on an upper surface of the diffusion layer 20.

The substrate 10 may be formed of an optical PET film.

A diffusion layer solution may be applied to the upper surface of the substrate 10 to form a diffusion layer 20. In this case, the diffusion layer 20 may be formed using a pair of rollers 101 and 102 so that a plurality of protrusions 22a of the diffusion layer 20 have a certain height.

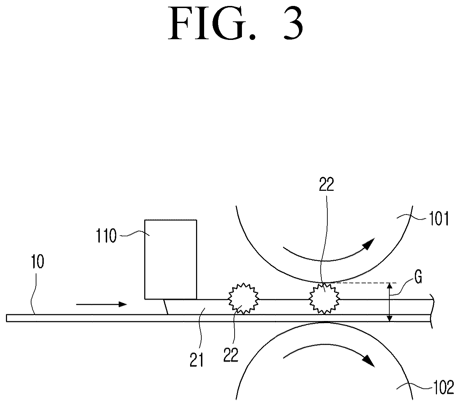

FIG. 3 is a conceptual view for explaining a method of forming a diffusion layer 20 of a glare-free film 1 according to one or more embodiments of the disclosure.

Referring to FIG. 3, the substrate 10 passes between the pair of rollers 101 and 102. An application nozzle 110 configured to apply the diffusion layer solution may be provided upstream of the pair of rollers 101 and 102 based on a moving direction (arrow direction) of the substrate 10.

The diffusion layer solution may be applied to the upper surface of the substrate 10 by the application nozzle 110. At this time, the diffusion layer solution contains a plurality of particles 22.

When the diffusion layer solution applied to the substrate 10 passes between the pair of rollers 101 and 102, the height of the plurality of protrusions 22a protruding from the upper surface of the diffusion layer solution is made uniform by the pair of rollers 101 and 102. Here, the height of the plurality of protrusions 22a refers to the height from the upper surface of the substrate 10 to the top of each of the plurality of protrusions 22a. The height of the plurality of protrusions 22a may be limited by a gap G between the pair of rollers 101 and 102.

While the diffusion layer solution applied to the substrate 10 passes through the pair of rollers 101 and 102, the diffusion layer solution flows down from the upper portions of the plurality of particles 22 and becomes flat, and the upper portions of the plurality of particles 22 protrude above the diffusion layer solution.

After a certain period of time, the diffusion layer solution hardens to form a flat portion 21 attached to the substrate 10, and the upper portions of the plurality of particles 22 protrude above the flat portion 21 to form the plurality of protrusions 22a. The plurality of particles 22 are fixed to the substrate 10 by the flat portion 21.

After the diffusion layer 20 is formed on the upper surface of the substrate 10, a low-reflection layer 30 is formed on the upper surface of the diffusion layer 20.

The low-reflection layer 30 may be formed using a solution. For example, the low-reflection layer 30 may be formed by applying a low-reflection solution to the upper surface of the diffusion layer 20. At this time, the low-reflection solution is applied so that the thickness of the low-reflection solution is smaller than the height of the plurality of protrusions 22a of the diffusion layer 20. In other words, the low-reflection solution is applied so that the height of the low-reflection solution applied to the upper surface of the flat portion 21 of the diffusion layer 20 is lower than the height of the plurality of protrusions 22a, that is, the height of the upper portions of the plurality of particles 22.

When the low-reflection solution is applied to the upper surface of the diffusion layer 20, the low-reflection solution flows down from the plurality of protrusions 22a of the diffusion layer 20, so that the plurality of protrusions 22a may protrude above the low-reflection layer 30. Accordingly, the low-reflection layer 30 may be formed around the plurality of protrusions 22a.

When the glare-free film 1 according to one or more embodiments of the disclosure is manufactured using the roller method described above, the height of the plurality of protrusions 22a protruding from the low-reflection layer 30 may be formed at a certain value. For example, the plurality of protrusions 22a protruding from the low-reflection layer 30 may be formed to have a height of less than a defined value.

Hereinafter, a display device 50 including a glare-free film 1 according to one or more embodiments of the disclosure will be described with reference to FIG. 4.

FIG. 4 is a cross-sectional view illustrating a display device 50 including a glare-free film 1 according to one or more embodiments of the disclosure.

Referring to FIG. 4, the display device 50 according to one or more embodiments of the disclosure may include a display panel 60, a glare-free film 1, and a housing 70.

The display panel 60 may be configured to display an image. The display panel 60 may include a liquid crystal display (LCD) panel, a light emitting diode (LED) display panel, an organic light emitting diode (OLED) display panel, or a quantum dots display panel.

The glare-free film 1 is disposed on the front surface of the display panel 60. The viewer may view an image being displayed on the display surface of the display panel 60 through the glare-free film 1.

The glare-free film 1 may include a substrate 10, a diffusion layer 20, and a low-reflection layer 30. The glare-free film 1 is the same as the above-described embodiment; therefore, a repeated description thereof is omitted.

The glare-free film 1 according to one or more embodiments of the disclosure having the structure as described above may have a glossiness of 20 GU or less. For example, the glare-free film 1 may have a glossiness of about 9 GU to 13 GU. Here, the glossiness refers to a glossiness measured at 60 degrees.

In addition, the glare-free film 1 according to one or more embodiments of the disclosure may have a SCI reflectivity of 2% or less. For example, the glare-free film 1 may have the SCI reflectivity of about 0.9% to 1.1%.

In addition, the glare-free film 1 according to one or more embodiments of the disclosure may have a haze of 30% or more.

Therefore, the glare-free film 1 according to one or more embodiments of the disclosure has a low reflectivity, a large haze, and a low glossiness, so that the external appearance may be prevented or minimized from being reflected on the glare-free film 1.

The housing 70 may be configured to accommodate the display panel 60. In other words, the display panel 60 is disposed inside the housing 70, and the front surface of the display panel 60 forms a display surface on which an image is displayed. An opening is formed on the front surface of the housing 70 to expose the display surface of the display panel 60.

Accordingly, the display device 50 according to one or more embodiments of the disclosure may prevent or minimize external appearances from being reflected on the display surface because the glare-free film 1 having a low reflectivity, a large haze, and a low glossiness is disposed on the display surface of the display device 50. Therefore, the immersion of the viewer into the image displayed on the display device 50 may be improved.

In addition, because the display device 50 according to one or more embodiments of the disclosure has the glare-free film 1 having a low reflectivity, a large haze, and a low glossiness disposed on the display surface, the external appearance may not be well reflected on the display surface when the display device 50 is turned off. Accordingly, the aesthetic effect of the display device 50 as an interior may be improved.

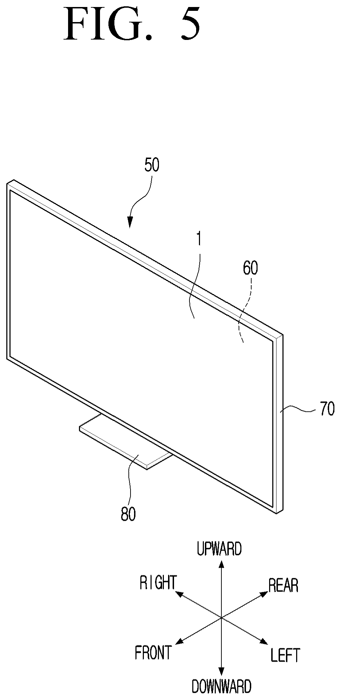

FIG. 5 is a perspective view illustrating a display device 50 including a glare-free film 1 according to one or more embodiments of the disclosure.

The display device 50 is a device that processes an image signal received from the outside and displays the processed image so that it can be visually recognized. In the following, the case where the display device 50 is a television (TV) is exemplified, but the display device 50 is not limited thereto. For example, the display device 50 may be implemented in various forms such as a monitor, a portable multimedia device, a portable communication device, etc. The form of the display device 50 is not limited as long as it is a device that can display an image.

Referring to FIG. 5, the display device 50 may include a housing 70, a display panel 60 configured to display an image, a glare-free film 1 disposed on the front surface of the display panel 60, and a stand 80 provided on the lower side of the housing 70 to support the housing 70.

The housing 70 forms the exterior of the display device 50. Various components for the display device 50 to display an image and perform various functions may be provided inside the housing 70.

The housing 70 illustrated in FIG. 5 is flat, but the shape of the housing 70 is not limited thereto. For example, the housing 70 may have a curved plate shape.

The display panel 60 may be configured to display an image facing forward. The display panel 60 may include a self-emitting display element or a received-emitting display element. The self-emitting display elements may visually output an image by emitting light on their own without a separate light source.

For example, a light emitting diode (LED), an organic light emitting diode (OLED), a quantum dot organic light emitting diode (QD-OLED), a micro LED made of inorganic light emitting materials, etc. may be an element that emits light on its own based on the current supplied to it.

The received-emitting display element may include a separate light source to visually output an image. For example, the received-emitting display element, a liquid crystal display (LCD), may change the arrangement of liquid crystals through current, but a separate light source is required to visually output an image through the changed arrangement of liquid crystals.

The display device 50 according to one or more embodiments of the disclosure may be applied to both a display panel 60 having self-emitting display elements and a display panel 60 having received-emitting display elements.

For convenience of description, a display panel 60 including received-emitting display elements will be described below as an example. However, in the case of the display panel 60 including self-emitting display elements, a light source part 200 described below is not included.

Referring to FIG. 5, the glare-free film 1 according to one or more embodiments of the disclosure is disposed on the front surface of the display panel 60. The viewer may view an image displayed on the front surface of the display panel 60 through the glare-free film 1.

The glare-free film 1 may include a substrate 10, a diffusion layer 20, and a low-reflection layer 30. Because the glare-free film 1 is the same as the above-described embodiment, a repeated description thereof is omitted.

The stand 80 is configured to stably support the housing 70. In FIG. 5, the stand 80 is disposed at the lower side of the housing 70, but the stand 80 is not limited thereto. As another example, the stand 80 may be disposed at the rear of the display device 50 and configured to support the housing 70 by fixing it to a wall.

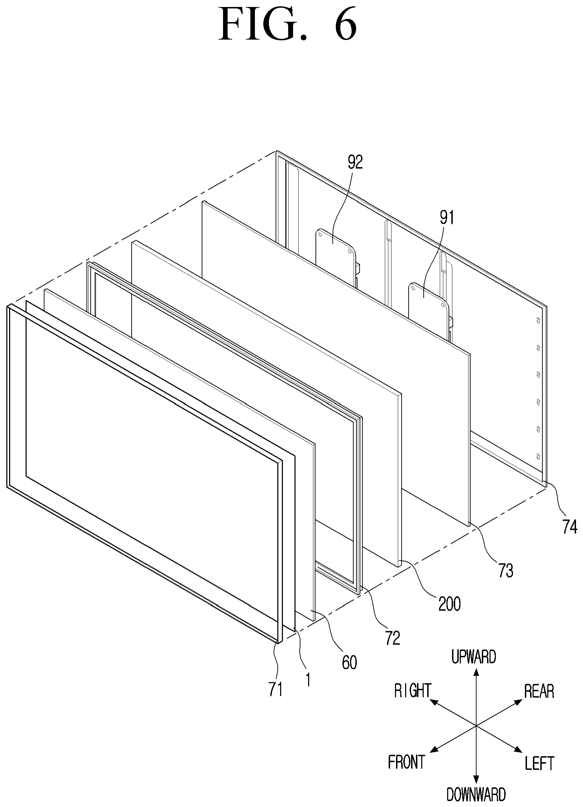

FIG. 6 is an exploded perspective view illustrating the display device 50 illustrated in FIG. 5 according to one or more embodiments of the disclosure.

Referring to FIG. 6, various components may be provided inside the housing 70 to display an image. For example, the housing 70 may be provided with a light source part 200 which is a surface light source, a display panel 60 configured to block or pass light emitted from the light source part 200, a control part 91 configured to control the operations of the light source part 200 and the display panel 60, and a power supply 92 configured to supply power to the light source part 200 and the display panel 60.

The display panel 60 is provided in front of the light source part 200 and is configured to block or pass light emitted from the light source part 200 to form an image. For example, the display panel 60 may be formed as a liquid crystal panel.

In addition, the housing 70 may include a bezel 71, a frame middle mold 72, a bottom chassis 73, and a rear cover 74 configured to support and fix the display panel 60, the light source part 200, the control part 91, and the power supply 92.

The light source part 200 may include point light sources configured to emit monochromatic light or white light, and may be configured to refract, reflect, and scatter light in order to convert light emitted from the point light sources into uniform surface light. For example, the light source part 200 may include a plurality of light sources configured to emit monochromatic light or white light, a diffusion plate configured to diffuse light incident from the plurality of light sources, a reflection sheet configured to reflect light emitted from the plurality of light sources and the rear surface of the diffusion plate, and an optical sheet configured to refract and scatter light emitted from the front surface of the diffusion plate.

The light source part 200 may emit a uniform surface light toward the front by refracting, reflecting, and scattering the light emitted from the light sources.

The control part 91 may include control circuitry configured to control the operations of the display panel 60 and the light source part 200. The control circuitry may be configured to process image data received from an external content source, transmit the image data to the display panel 60, and transmit dimming data to the light source part 200.

The power supply 92 may supply power to the display panel 60 and the light source part 200 so that the light source part 200 outputs surface light and the display panel 60 blocks or passes light emitted from the light source part 200.

The control part 91 and the power supply 92 may be implemented as a printed circuit board and various circuitry mounted on the printed circuit board. For example, power circuitry may include capacitors, coils, resistors, processors, etc., and a power circuit board on which they are mounted. In addition, control circuitry may include memory, processor, and a control circuit board on which they are mounted.

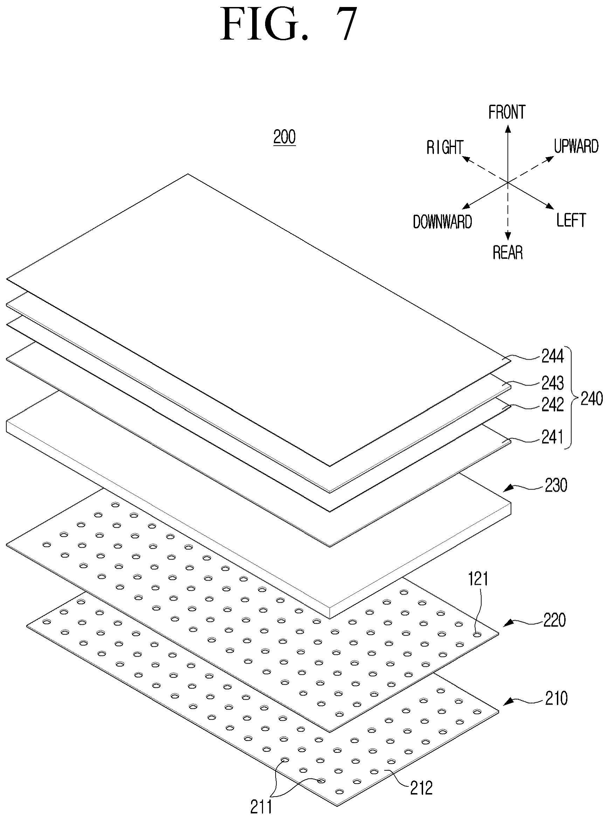

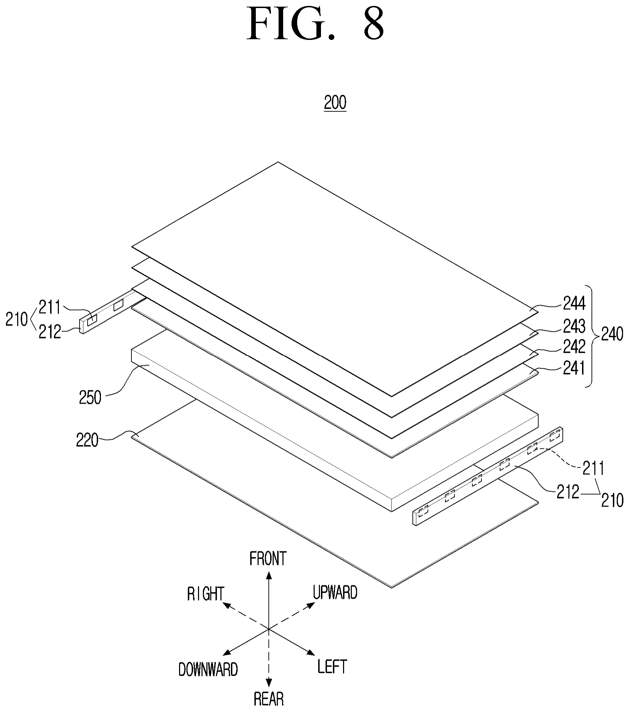

Hereinafter, the structure of the light source part 200 will be described in detail with reference to FIGS. 7 and 8.

FIG. 7 is an exploded perspective view illustrating a light source part of the display device illustrated in FIG. 6 according to one or more embodiments of the disclosure. For reference, FIG. 7 shows a direct-type light source part.

Referring to FIG. 7, the light source part 200 may include a light source assembly 210 configured to generate light, a reflective sheet 220 configured to reflect light, a diffuser plate 230 configured to evenly diffuse light, and an optical sheet 240 configured to improve brightness of the emitted light.

The light source assembly 210 may include a plurality of light sources 211 configured to emit light and a board 212 configured to support and fix the plurality of light sources 211.

The plurality of light sources 211 may be arranged in a defined pattern so that light is emitted with uniform brightness. The plurality of light sources 211 may be arranged at regular intervals. For example, as illustrated in FIG. 7, the plurality of light sources 211 may be arranged so that rows and columns thereof are aligned. In other words, the plurality of light sources 211 may be arranged so that four adjacent light sources form approximately a square. However, the arrangement of the plurality of light sources 211 is not limited thereto. In addition, the plurality of light sources 211 may be arranged in various patterns as long as light can be emitted with uniform brightness.

The light sources 211 may be implemented as an element configured to emit monochromatic light (light of a specific wavelength, for example, blue light) or white light (for example, light mixed with red light, green light, and blue light) in various directions when power is supplied. For example, the light sources 211 may include light emitting diodes (LEDs).

The board 212 may fix the plurality of light sources 211 so that the positions of the light sources 211 do not change. In addition, the board 212 may be configured to supply power to the plurality of light sources 211 so that the plurality of light sources 211 emit light.

The board 212 may be implemented with a synthetic resin, reinforced glass, a printed circuit board (PCB), etc., on which the plurality of light sources 211 are fixed and conductive power supply lines for supplying power to the light sources 211 are formed.

The reflective sheet 220 may reflect light emitted from the plurality of light sources 211 in a forward direction or in a direction close to the forward direction.

A plurality of through holes 221 are formed in the reflective sheet 220 at positions corresponding to the plurality of light sources 211 of the light source assembly 210, respectively. Accordingly, the light sources 211 of the light source assembly 210 may pass through the through holes 221 and protrude forward of the reflective sheet 220. The light sources 211 may be inserted into the through holes 221. Accordingly, the plurality of light sources 211 may emit light toward the front of the reflective sheet 220.

The plurality of light sources 211 may emit light in various directions in front of the reflective sheet 220. Light may be emitted from the light sources 211 toward the diffuser plate 230. In addition, light may be emitted from the light sources 211 toward the reflective sheet 220.

The reflective sheet 220 may reflect light emitted toward the reflective sheet 220 toward the diffuser plate 230. In other words, the reflective sheet 220 may reflect light incident from the light sources 211 toward the diffuser plate 230.

The reflective sheet 220 may be manufactured by coating a high reflective material on a base material. For example, the reflective sheet 220 may be manufactured by coating a polymer having a high reflectivity on the base material such as polyethylene terephthalate (PET), etc.

Light emitted from the light sources 211 passes through the diffuser plate 230 and the optical sheet 240. When light is incident on the diffuser plate 230 and the optical sheet 240, some of the incident light is reflected on the surface of the diffuser plate 230 and the surface of the optical sheet 240. The reflective sheet 220 may reflect the light reflected by the diffuser plate 230 and the optical sheet 240 toward the diffuser plate 230.

The diffuser plate 230 may be provided in front of the light source assembly 210 and the reflective sheet 220, and may be configured to evenly disperse light emitted from the light sources 211 of the light source assembly 210.

The plurality of light sources 211 are positioned at various locations on the rear of the light source part 200. The plurality of light sources 211 are arranged at equal intervals on the rear of the light source part 200, but brightness unevenness may occur depending on the positions of the plurality of light sources 211.

The diffuser plate 230 may be configured to diffuse light emitted from the plurality of light sources 211 in order to remove or alleviate the unevenness of brightness caused by the plurality of light sources 211. In other words, the diffuser plate 230 may be configured so that the non-uniform light from the plurality of light sources 211 passes through the diffuser plate 230 and becomes uniform light, which is then uniformly emitted from the front surface of the diffuser plate 230.

The optical sheet 240 may include various types of sheets for improving brightness and uniformity of brightness. For example, the optical sheet 240 may include a diffuser sheet 241, a first prism sheet 242, a second prism sheet 243, a reflective polarizing sheet 244, etc.

The diffuser sheet 241 may be configured to diffuse light to ensure uniformity of brightness. Light emitted from the light sources 211 may be diffused by the diffuser plate 230, and may be diffused again by the diffuser sheet 241 included in the optical sheet 240.

The first and second prism sheets 242 and 243 may be configured to increase brightness by concentrating the light diffused by the diffuser sheet 241. Each of the first and second prism sheets 242 and 243 may include prism patterns in the shape of triangular prisms. The plurality of prism patterns may be arranged adjacently to form a plurality of band shapes.

The reflective polarizing sheet 244 is a type of polarizing film, and may be configured to transmit some of the incident light and reflect some of the incident light in order to improve brightness. For example, the reflective polarizing sheet 244 may transmit polarized light in the same direction as the predetermined polarization direction of the reflective polarizing sheet 244 and reflect polarized light in a different direction from the polarization direction of the reflective polarizing sheet 244.

In addition, the light reflected by the reflective polarizing sheet 244 may be recycled inside the light source part 200. The brightness of the display device 50 may be improved by this light recycling.

The optical sheet 240 is not limited to the sheets or films illustrated in FIG. 7, and may include various sheets or films, such as a protective sheet, etc.

FIG. 8 is an exploded perspective view illustrating a light source part of the display device illustrated in FIG. 6 according to one or more embodiments of the disclosure. For reference, FIG. 8 shows an edge-type light source part 200.

Referring to FIG. 8, the light source part 200 may include a light source assembly 210 configured to emit light, a light guide plate 250 configured to disperse light, a reflective sheet 220 configured to reflect light, and an optical sheet 240 configured to improve light brightness.

The light source assembly 210 may include a plurality of light sources 211 configured to emit light and a board 212 configured to support and fix the plurality of light sources 211.

The plurality of light sources 211 may be uniformly arranged on the side of the light source part 200 as illustrated in FIG. 8, and may be configured to emit light toward the center of the light source part 200.

The plurality of light sources 211 may be arranged at equal intervals so that the light emitted from the plurality of light sources 211 has as uniform a brightness as possible. For example, as illustrated in FIG. 8, the plurality of light sources 211 may be arranged at equal intervals on the left and right sides of the light source part 200. However, the arrangement of the light sources 211 is not limited to that illustrated in FIG. 8. The light sources 211 may be arranged on only one of the left and right sides of the light source part 200.

The light sources 211 may be implemented as elements configured to emit monochromatic light (light of a specific wavelength, for example, blue light) or white light (light mixed with light of various wavelengths) in various directions when power is supplied. For example, the light sources 211 may include light emitting diodes (LEDs).

The board 212 may be configured to support and fix the plurality of light sources 211 so that the positions of the light sources 211 do not change. In addition, the board 212 may be configured to supply power to the plurality of light sources 211 so that the plurality of light sources 211 emit light.

The board 212 may be disposed on the side of the light source part 200 together with the plurality of light sources 211. For example, as illustrated in FIG. 8, the boards 212 may be disposed on the left and right sides of the light source part 200. However, the arrangement of the boards 212 is not limited to that illustrated in FIG. 8. The board 212 may be arranged on only one of the left and right sides of the light source part 200.

The board 212 may be implemented with a synthetic resin, reinforced glass, a printed circuit board (PCB), etc., on which the plurality of light sources 211 are fixed and conductive power supply lines for supplying power to the light sources 211 are formed.

The light guide plate 250 may be configured to change the direction of light incident from the light source assembly 210 on the side thereof and emit light toward the front thereof.

In addition, the light guide plate 250 may be configured to disperse and emit light incident from the light source assembly 210 on the side thereof toward the front of the light guide plate 250.

For example, in order to change the direction of light propagation, a plurality of convex stripes may be formed on the front surface of the light guide plate 250, and a plurality of dots may be formed on the rear surface of the light guide plate 250.

Because the light source assembly 210 is disposed on the side of the light source part 200, unevenness in brightness may occur depending on the position of the light source assembly 210. Accordingly, the light guide plate 250 may be configured to diffuse the light emitted from the light source assembly 210 within the light guide plate 250 in order to eliminate or alleviate the unevenness in brightness due to the position of the light source assembly 210.

For example, in order to diffuse light, the light guide plate 250 may have a milky color. Light incident into the light guide plate 250 may travel in various directions depending on the incident angle.

The light guide plate 250 may be formed of poly methyl methacrylate (PMMA), transparent polycarbonate (PC), etc.

The reflective sheet 220 may be provided at the rear of the light guide plate 250, and may be configured to reflect light emitted through the rear surface of the light guide plate 250 toward the light guide plate 250.

The reflective sheet 220 may be manufactured by coating a material having a high reflectivity on a base material. For example, the reflective sheet 220 may be manufactured by coating a polymer having a high reflectivity on the base material such as polyethylene terephthalate (PET), etc.

The optical sheet 240 may include various types of sheets for improving brightness and uniformity of brightness. For example, the optical sheet 240 may include a diffuser sheet 241, a first prism sheet 242, a second prism sheet 243, and a reflective polarizing sheet 244.

The diffuser sheet 241 may be configured to diffuse light to ensure uniformity of brightness. Light emitted from the light sources 211 may be diffused by the light guide plate 250, and diffused again by the diffuser sheet 241 included in the optical sheet 240.

The light passing through the diffuser sheet 241 is diffused in a direction parallel to the diffuser sheet 241, thereby decreasing the brightness.

The first and second prism sheets 242 and 243 may be configured to increase brightness by concentrating the light diffused by the diffuser sheet 241.

The first and second prism sheets 242 and 243 may include prism patterns in the shape of a triangular prism. The plurality of prism patterns may be arranged adjacently to form a plurality of band shapes. At this time, the direction in which the prism patterns of the first prism sheet 242 are arranged and the direction in which the prism patterns of the second prism sheet 243 are arranged may be orthogonal to each other.

Light passing through the first and second prism sheets 242 and 243 may have a viewing angle of approximately 70 degrees, and the brightness may be improved because the light travels in front of the light source part 200.

The reflective polarizing sheet 244 is a type of polarizing film, and may be configured to transmit some of the incident light and reflect some of the incident light in order to improve brightness. For example, the reflective polarizing sheet 244 may be configured to transmit polarized light in the same direction as the predetermined polarization direction of the reflective polarizing sheet 244 and reflect polarized light in a different direction from the polarization direction of the reflective polarizing sheet 244.

In addition, the light reflected by the reflective polarizing sheet 244 may be recycled inside the light source part 200. The brightness of the display device 50 may be improved by this light recycling.

The optical sheet 240 is not limited to the sheets or films illustrated in FIG. 8, and may include various sheets or films, such as a protective sheet, etc.

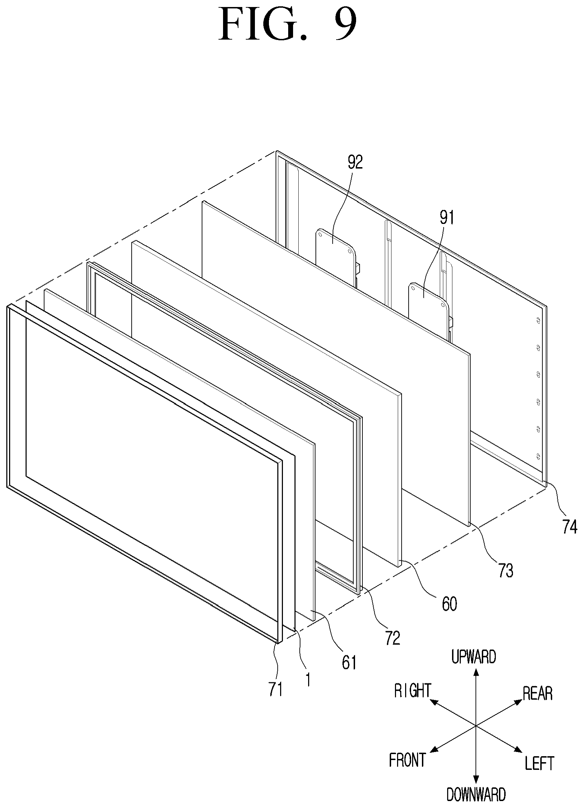

FIG. 9 is an exploded perspective view illustrating a display device including a glare-free film 1 according to one or more embodiments of the disclosure.

Referring to FIG. 9, various components may be provided inside the housing 70 (see Fig. 5) to display an image. For example, the housing 70 may be provided with a display panel 60 configured to display an image, a control part 91 configured to control the operation of the display panel 60, and a power supply 92 configured to supply power to the display panel 60.

The display panel 60 may include self-emitting display elements. The self-emitting display elements may be configured to visually output an image by emitting light on their own without a separate light source.

For example, the self-emitting display element may include a light emitting diode (LED), an organic light emitting diode (OLED), a quantum dot-organic light emitting diode (QD-OLED), a micro LED made of an inorganic light emitting material, etc.

A cover glass 61 may be disposed on the front side of the display panel 60. The glare-free film 1 according to one or more embodiments of the disclosure may be disposed on the front surface of the cover glass. The viewer may view an image displayed on the front surface of the display panel 60 through the glare-free film 1.

The glare-free film 1 may include a substrate 10, a diffusion layer 20, and a low-reflection layer 30. Because the glare-free film 1 is the same as the above-described embodiment, a repeated description thereof is omitted.

In addition, the housing 70 may include a bezel 71, a frame middle mold 72, a bottom chassis 73, and a rear cover 74 configured to support and fix the display panel 60, the control part 91, and the power supply 92.

The control part 91 may include control circuitry configured to control the operation of the display panel 60. The control circuitry may be configured to process image data received from an external content source and transmit the image data to the display panel 60 to display an image.

The power supply 92 may supply power to the display panel 60 so that the display panel 60 displays an image.

The control part 91 and the power supply 92 may be implemented as a printed circuit board and various circuitry mounted on the printed circuit board. For example, power circuitry may include capacitors, coils, resistors, processors, etc., and a power circuit board on which they are mounted. In addition, control circuitry may include memory, processor, and a control circuit board on which they are mounted.

The display device 50 as described above may prevent or minimize external appearance from being reflected on the front surface of the display panel 60 by disposing the glare-free film 1 according to one or more embodiments of the disclosure on the front surface of the display panel 60.

In the foregoing, the disclosure has been shown and described with reference to various embodiments. However, it is understood by those skilled in the art that various changes may be made in form and detail without departing from the scope of the disclosure as defined by the appended claims and equivalents thereof.

## Claims

1. A glare-free film comprising:
a substrate;
a diffusion layer on an upper surface of the substrate and comprising a plurality of protrusions protruding from an upper surface of the diffusion layer; and
a low-reflection layer on the upper surface of the diffusion layer,
wherein the plurality of protrusions of the diffusion layer protrude to a height greater
than a height of an upper surface the low-reflection layer.

2. The glare-free film of claim 1, wherein a glossiness of the glare-free film is 20 GU or less.

3. The glare-free film of claim 1, wherein a specular common included (SCI) reflectance of the glare-free film is 2% or less.

4. The glare-free film of claim 1, wherein
a ratio between an area of the plurality of protrusions and an area of the diffusion layer is greater than or equal to 30% and less than or equal to 40%.

5. The glare-free film of claim 1, wherein
a haze of the diffusion layer is 30% or more.

6. The glare-free film of claim 1, wherein
the plurality of protrusions are a plurality of particles wherein the diffusion layer further comprises a flat portion having the plurality of particles fixed thereon,
wherein the flat portion is a solution, and
wherein a mixing ratio of the solution and the plurality of particles is 8 to 1.

7. The glare-free film of claim 6, wherein
the solution is a photocurable polymer, and
wherein the plurality of particles are silica.

8. The glare-free film of claim 6, wherein
a size of the plurality of particles is 2.7 ± 0.6*µ*m.

9. The glare-free film of claim 1, wherein
the substrate is a polyethylene terephthalate (PET) film or a tri-acetly-cellulose (TAC) film.

10. The glare-free film of claim 9, wherein
the PET film is an optical PET film containing a ultraviolet (UV) absorber or an optical PET film manufactured by a monoaxial/biaxial stretching method.

11. The glare-free film of claim 1, wherein
a refractive index of the diffusion layer is not equal to a refractive index of the low-reflection layer.

12. A display device comprising:
a display panel; and
a glare-free film on a front surface of the display panel, comprising:
a substrate;
a diffusion layer on an upper surface of the substrate and comprising a plurality of protrusions protruding from an upper surface of the diffusion layer; and
a low-reflection layer on the upper surface of the diffusion layer,
wherein the plurality of protrusions of the diffusion layer protrude to a height greater
than a height of an upper surface the low-reflection layer.

13. The display device of claim 12, wherein
a glossiness of the glare-free film is 20 GU or less.

14. The display device of claim 12, wherein
a specular common included (SCI) reflectance of the glare-free film is 2% or less.

15. The display device of claim 12, wherein
a haze of the glare-free film is 30% or more.
